**Europäisches Patentamt**

**European Patent Office**

**Office européen des brevets**

(19)

(11) Veröffentlichungsnummer: **0 456 883 A1**

## (12) EUROPÄISCHE PATENTANMELDUNG

(21) Anmeldenummer: 90118428.3

(22) Anmeldetag: 26.09.90

(51) Int. Cl.⁵: **B32B 31/20**

(30) Priorität: 12.05.90 DE 4015330

(43) Veröffentlichungstag der Anmeldung:
21.11.91 Patentblatt 91/47

(84) Benannte Vertragsstaaten:
AT BE CH DE DK ES FR GB GR IT LI LU NL SE

(71) Anmelder: **Schäfer, Hans-Jürgen, Dipl.-Ing.**
**Rather Strasse 17**
**W-4150 Krefeld(DE)**

(72) Erfinder: **Schäfer, Hans-Jürgen, Dipl.-Ing.**
**Rather Strasse 17**
**W-4150 Krefeld(DE)**

(54) **Verfahren und Vorrichtung zur Beschichtung und kontinuierlichen Lamination.**

㊼ Ein mit Folien (4) kaschiertes Laminat bzw. Platte wird mit einer Vorrichtung hergestellt,die eine Doppelband-presse benutzt,deren unteres Preßband (3) doppelt so lang ist,wie das obere Preßband, gegebenenfalls ist die vordere untere Trommel(23) um ein Drittel bis ein Viertel im Durchmesser kleiner wie die übrigen. Auf den Bandoberseiten (3) werden Folien (4) und flächenförmige Trägerstoffe(5) wie Papier und Gewebe mittels Laminierwalzen (13) mit Harzschmelzen (19) laminiert,und dann je zur Hälfte von der hinteren oberen Trommel-(2) gegen die Produktionsrichtung und von der vorderen unteren Trommel (23) in Produktionsrichtung mittels Band- und Strahlertemperatur (6) im Vakuum (9) vorgehärtet,mit Kalibrierwalzen (12) zusammengeführt,und mit einer Doppelband - presse ausgehärtet.

Diese Vorrichtung faßt die Laminatherstellung in einem Herstellungsprozeß zusammen,und kann daher als "Laminatmaschine"bezeichnet werden.

EP 0 456 883 A1

Die Erfindung betrifft eine Vorrichtung zur Beschichtung von flächenförmigen Trägerstoffen mit Reaktionsharzschmelzen,Vorhärtung vom Resol in den Resitolzustand,sowie anschließender Aushärtung mit einer Doppelbandpresse, sowie das Verfahren.

Zur Herstellung von Laminaten aus mehreren Trägerstoffen und Reaktionsharzen sind die verschiedensten Herstellungsverfahren bekannt.Das gebräuchlichste ist die Imprägnierung von Trägerstoffen bestehend aus Glasgewebe,Glasmatte,sowie Papier mit Reaktionsharzlösungen wie Epoxid-,Polyester-,Phenol-,und Melaminharzen bei anschließender Trocknung in einem horizontalen oder vertikalen Trockner.Die so vorgehärteten sogenannten Prepregs werden in Bögen geschnitten und zwischen Edelstahlblechen in Mehretagenpressen unter Druck und Temperatur verpreßt.

Seit sich die Herstellung derartiger Laminate mit Doppelbandpressen durchzusetzen beginnt,beschäftigt man sich mit der vollkontinuierlichenProduktion.

Da die Imprägnierung einen kontinuierlichen Herstellungsprozeß darstellt,war dieser nun mit einer Doppelbandpresse zu kombinieren.

Dies ist beispielsweise in der DE-AS-2722262 sowie in derDE-OS-2613081 beschrieben.Diese Verfahren gehen von lösungsmittelhaltigen Reaktionsharzen aus und haben die durch schnellhärtende Harze und heiße,klebrige Prepregs auftretenden Probleme nicht gelöst.Die DE-3324302 beschreibt eine Vorrichtung,mit der es möglich ist,Reaktionsharze aus der Schmelze vor einer Doppelbandpresse aufzutragen.Bei dieser Vorrichtung sind die Harzauftragsstationen so unterschiedlich weit von der Härtungszone der Presse entfernt,daß es nicht gelingen kann,den gleichen Vorhärtungszustand des Harzes vordem Eintritt in die Presse zu erzielen. Dies führt zu uneinheitlichen Produkten und in Folge zu Verwindung und Verwölbung.

Die erfindungsgemäße Vorrichtung benutzt nun erstmalig eine Doppelbandpresse für die Beschichtung,Vorhärtung,Entgasung und Verpressung von Laminaten.Mit der erfindungsgemäßen Vorrichtung ist es durch die Verwendung von zwei unterschiedlich langen Preßbändern,wobei das untere doppelt so lang ist wie dasobere, erstmalig möglich,auf zwei gleichlangen Härtungsstecken auf dem gleichen Temperaturniveau bis zum Einlauf in die Presse einen einheitlichen Vorhärtungszustand zu gewährleisten. Auf die hintere obere Umlenktromme (23) und die vorgezogene untere Umlenktrommel (2) werden die Trägerstoffe auf einem Viertel des Trommelumfangs dem Preßband zugeführt.Anschließen wird Reaktionsharz über eine Breitschlitzdüse( 7) sowohl auf die zuunterst liegende Kupferfolie,wie auch mittels heizbarer Laminierwalzen (13) auf jede Trägerbahn seperat gegeben,sodaß jede Trägerbahn sowohl von oben,wie auch von unten durchtränkt und von Luftblasen befreit wird.Der Trägerstoff (5) wird mit der Harzbeschichteten Laminierwalze (13) in die bereits durchgedrückte Harzschmelze laminiert.Bis zu vier Lagen können mit dieser Vorrichtung pro Seite laminiert werden. Das Reaktionsharz (8) wird evakuiert(9) und an alle Stationen zur gleichen Zeit gepumpt. Die aufeinander laminierten Materialien werden von einem gekühlten Kalibrierwalzenpaar (12) auf einheitliche Dicke gebracht. Anschließend wird durch die über den Bändern angeordneten Infrarotstrahler und die Bandtemperatur eine gleichmäßige Vorhärtung erzielt,wobei unter gleichzeitigem Vakuum(9)im Stahlerberreich die restlichen Luftblasen entfernt werden.

Die obere Laminathälfte wird zunächst entgegen der Produktionsrichtung geführt und vorgehärtet.Nach der Umlenkung der oberen Laminathälfte auf der vorderen ,oberen Umlenktrommelwerden beide Laminathälften vereinigt.In der Presse erfolgt dann die Aushärtung.

Zur Vermeidung von Falten und zur Erzielung eines guten Imprägnierergebnisses sowie zur Aufrechterhaltung der Warenbahnspannung werden Folien und Trägerstoffe über heizbare,verstellbare Walzen(17) geführt,bevor sie der Laminierwalze zugeführt werden.

Die gleichmäßige Erwärmung und die Führung von heißen,klebrigen Prepregs stellt ein bisher nicht gelöstes Problem dar.

Die erfindungsgemäße Vorrichtung führt durch die Trägerstoff und Harzzuführung auf den Umlenktrommeln zu faltenfreien und luftblasenfreien Gelegen ,die durch die Preßbandoberfläche und die Infrarotstrahler gleichmäßig auf Reaktionstemperatur gebracht wer den.Da sich die Kupferfolie mit üblicherweise 17,5 bzw 35μm Dicke bei Erwärmung ausdehnt und wellt,läßt sie sichnicht Faltenfrei auf ein klebriges heißes Prepreg auflegen.Gleichfalls läßt sich nicht verhindern ,das bei dem Auflegen von Kupferfolie Luft mit eingeschlossen wird,welche die Qualität der Erzeugnisse nachteilig beeinflußt.

Die erfindungsgemäße Vorrichtung geht nun davon aus,daß die - Kupferfolie zuunterst liegt.Dadurch findet eine optimale Benetzung der Kupferoberfläche mit Harz statt,Falten werden vermieden und beide Laminathälften in horizontaler Lage gleichmäßig hergestellt.

Durch die vollständige Belegung der oberen Preßbandoberfläche wird vermieden,daß Staub zwischenPreßband und Kupferfolie gelangt.Die Bandverschmutzung wird daher im Wesentlichen durch Kupferabrieb verursacht,der teilweise oxidiert.Dieser Kupferabrieb läßt sich nicht durch die bisher üblichen mechanischen Reinigungsverfahren entfernen.

Es muß daher eine erfindungsgemäße Naßreinigungsvorrichtung benutzt werden.Diese besteht aus zwei oder mehreren Schwammwalzen (10).Auf diese wird eine Reinigungsflüssigkeit z.B. Salzsäurelösung und Wasserstoffperoxid gegeben,die sie auf die Bandoberfläche aufträft.Ein Gummiabstreifer zieht die Flüssigkeit vom Band,eine Wasserdüse spült Reste herunter,und eine zweite oder dritte Schwammwalze nimmt die noch vorhandene Feuchtigkeit auf.

Die Vorrichtung gemäß Anspruch 1 löst in für den Fachmann überraschenderweise alle derzeit bei der Herstellung von Laminaten mit Doppelbandpressen bekannten Probleme und führt auf Grund der günstigen Energiebilanz (das Prepreg braucht nur einmal erwärmt zu werden,es brauchen keine Lösungsmittel verbrannt zu werden)zu einer bisher noch nicht erreichten ökologisch und ökonomisch optimalen Produktion mit hohem Qualitätsstand der Erzeugnisse.

Mit dieser erfindungsgemäßen Vorrichtung werden auch die Probleme gelöst,die bisher bei der Imprägnierung von schnellreagierenden Harzen in Bezug auf die gleichmäßigen Prepregeigenschaften hervorgerufen durch ungleichmäßige Luftmengenverteilung in Lufttrocknern entstehen.

Zur Vermeidung von Vorhärtungsdifferenzen über die Prepregbreite können die Prepregs auf dem Trockner nur vom Lösungsmittel befreit werden,ohne sie vorzuhärten. Die nicht vorgehärteten Prepregs lassen sich dann auf der erfindungsgemäßen Vorrichtung vorhärten , entgasen und verpressen.

Da das heiße Prepreg eine niedrigviskose Harzschmelze besitzt, muß mit einer erfindungsgemäßen Maßnahme verhindert werden,daß das Harz beim Eintritt in die Presse herausläuft.Dies wird bei Verwendung der Schmelzimprägnierung durch die Einstellung der Beschichtungsbreite der Breitschlitzdüsen (7) erreicht.Der unbeschichtete Rand bleibt bei eine isochoren Presse drucklos. Bei einer isobaren Presse muß der Randbereich mit einer zusätzlichen Randbeschichtung (14) mittels einer schnell härtenden Harzmischung (Polyester/peroxid) versiegelt werden. Bei Verwendung von bereits imprägnierten Prepregs wird der Rand mit einem Infrarotrandstrahler ausgehärtet.

Wird wegen zu hoher Viskosität bzw. Reaktivität ein Pulverharz eingesetzt,so muß die erfindungsgemäße Breitschlitzdüse (7) mit einem Pulvertrichter (15) ausgestattet werden. Die Filmdicke wird am Austritt der Düse mit einem Rakelmesser (16) exakt eingestellt.

Sollen die Trägerstoffe nur beschichtet und vorgehärtet werden,damit sie später in einer Etagenpresse verarbeitet werden können, so läßt sich die erfindungsgemäße Vorrichtung auch als Infrarot-Vakuumbeschichtungsanlage verwenden,indem im Bereich der Preßfläche kein Druck ausgeübt wird und dieser Bereich gekühlt wird.

Auf Grund der Vielseitigkeit der erfindungsgemäßen Vorrichtung können auch Spanplatten mit Melaminpapieren sowie Waben und - Schaumkerne mit Gewebedeckschichten versehen werden.

Zur Beschichtung von Platten mit Papieren oder Geweben wird gemäß der Zeichnungen Blatt 3 eine Vorrichtung benutzt, die eine um etwa ein Drittel im Durchmesser kleinere vordere Beschichtungswalze (23) gegenüber den Umlenkrollen (2) aufweist.

Dadurch werden die beschichteten Papiere oder Gewebe in einem Stumpfen Winkel zur Preßfläche (1) befördert.Der Strahlerbereich (6) wird geteilt,sodaß die Platten (24) über eine Rollenbahn (25) in den unter Vakuum (9) stehenden Strahlerbereich (6) eingebracht werden können.

Die Platten werden im Vakuum durch Infrarotstrahler von der Oberflächenfeuchtigkeit befreit und aufgewärmt.

Die beschichteten und Vorgehärteten Gewebe oder Papiere werden dann mit den Laminierwalzen (12) vor Eintritt in die Preßzone(1) auf die Plattenoberfläche von unten und oben aufgetragen. Die kaschierte Platte wird dann in der Presse ausgehärtet.

Will man jedoch beispielsweise Glasgewebe beschichten,so stellen sich auf Grund der Fadendichte und Kreu zungspunkte die Penetratiosprobleme. Gleichzeitig entstehen Probleme aus den Umfangsgeschindigkeiten der aufeinander liegenden Gewebelagen bei der oberen ,vorderen Umlenktromme (2). Diese Probleme werden durch die erfindungsgemäße Vorrichtung dadurch gelöst, daß die Beschichtungswalzen einen (23) etwa doppelt so großen Durchmesser aufweisen wie die Umlenktrommeln (2) Dadurch wird die Penetrationsstrecke vergrößert und die Umfangsdifferenzen an der oberen Umlenktommel (2) verringert. Dies ist in Zeichnungen Blatt 4 dargestellt.

Das erfindungsgemäße Verfahren soll nachstehend an einem Beispiel erläutert werden.

Herstellung von Basismaterial für gedruckte Schaltungen :
Typ : Epoxidglasgewebe nach NEMA FR4

Dicke: 1,5 mm

Kaschierung  17,5 µ m

Lagenzahl    8

Harzpulverrezeptur :

49  Gew.Tl. Epoxidharz   Ep. Äqu. 470 -540  Schmelzp.  65-79°C

 8  Gew. Tl. Phenolnovolak Äquivalent 240-265   Schmelzp. 78-90°C

38  Gew.Tl. Bromiertes Epoxidharz Ep.Äqu. 305-355 Br  50 % SP.  58-62°C

 4  Gew. Tl Dicyandiamid

 1  Gew. Tl 2Methylimidazol

--------------------------

100.0 Gew. Tl.

B-Zeit 170°C = 35 sec.

Gewebe  :

200 g/qm  US Typ 7628

Beharzung  : 42 %

Kupferkaschierung : 17,5 µm

Laminateigenschaften :
  Glasumwandlungstemp.    136°C
  HPC  Test              > 3 h
    Dimensionsstabilit. .< 0.1 ‰

Maschinenparameter   Laminatmaschine :

Preßzone   :    4 m

Druck     :   15 bar

Preßtemperatur : 175 °C

Bandtemperatur : 155°C

Aufheizwalzen  :  200°C

Laminierwalzen   180 °C

Geschwindigkeit :  4m /min

Vakuum    <  30 mbar

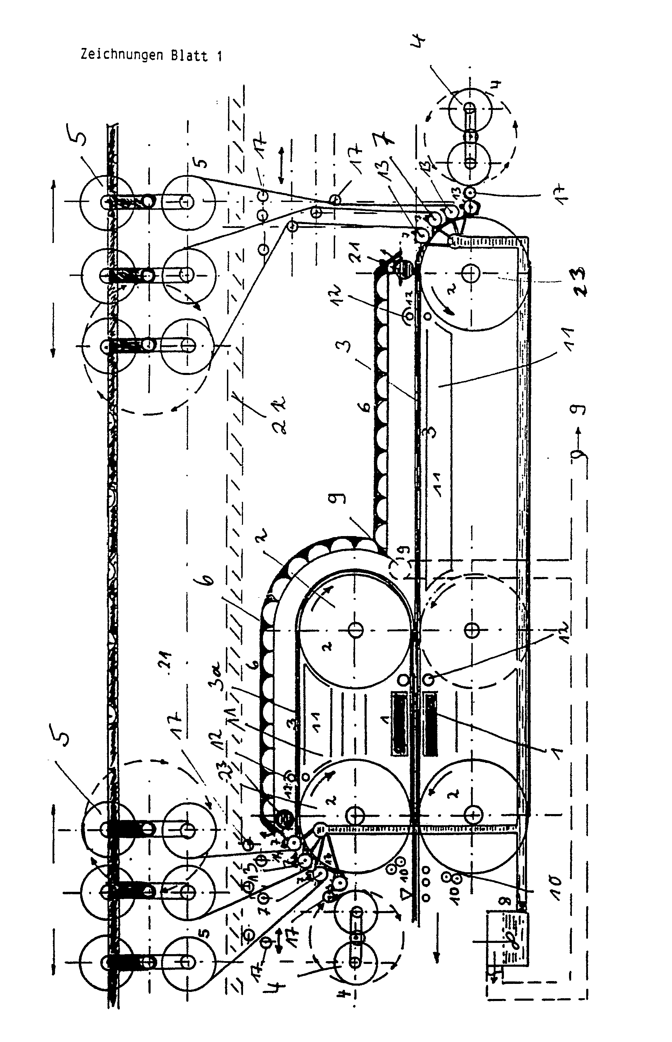

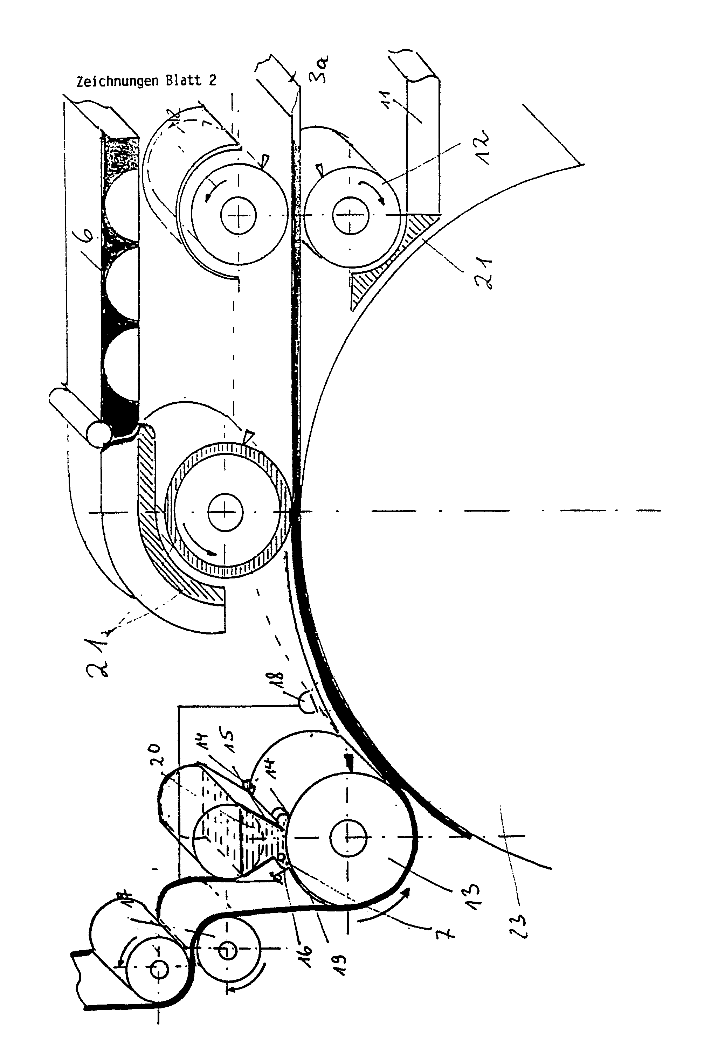

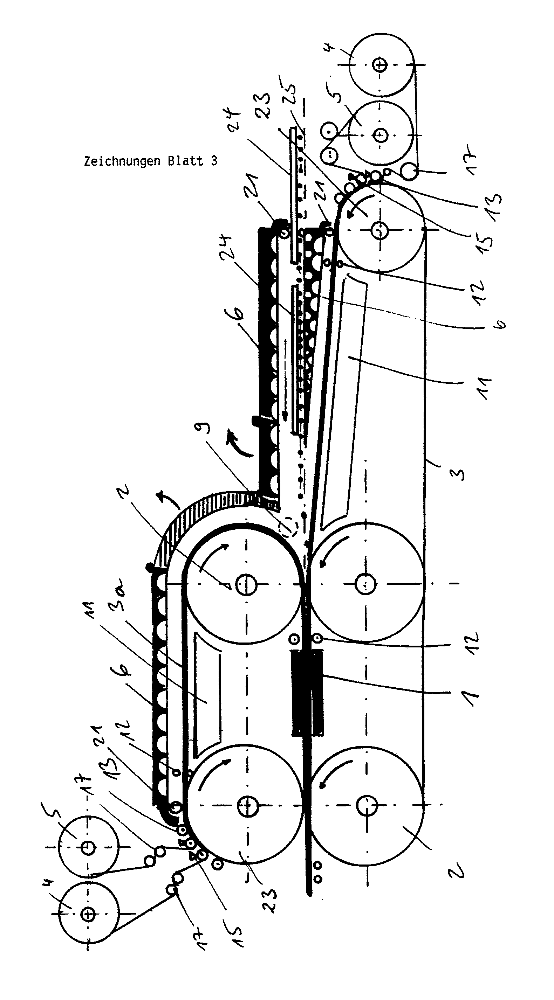

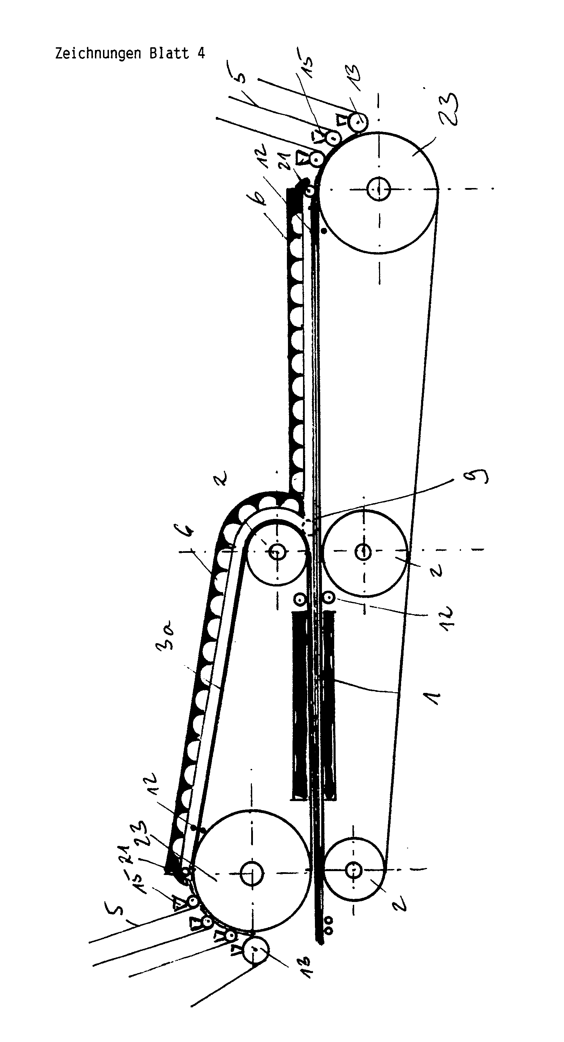

## Patentansprüche

1. Laminatmaschine zur Beschichtung und kontinuierlichen Lamination von Folien (4)und flächenförmigen Trägerstoffen (5) mit lösungsmittelfreien Reaktionsharzen insbesondere zur Herstellung von Basismaterialien für gedruckte Schaltungen sowie Dekorlaminate und Plattendirektbeschichtung dadurch gekennzeichnet,daß eine Doppelbandpresse verwendet wird, deren unteres Preßband (3)etwa doppelt so lang ist, wie das obere Preßband (3a) , die Harzdosierung (7) und Trägerstoffaufgabe (5) auf den außerhalb der Preßflächen liegenden Bandoberseiten erfolgt,sodaß eine Imprägnation aus derSchmelze (19) durchgeführt und die zu imprägnierenden Trägerstoffe (5) durch Laminierwalzen (13) in die aufdosierte Harzschmelze ( 19 ) bei definierter Temperatur laminiert,und in den verpreßfähigen Zustand vorgehärtet sowie unter Druck und Temperatur verpreßt werden.

2. Verfahren nach Anspruch 1 dadurch gekennzeichnet,daß die Zuführung der Folien (4) und Trägerstoffe (5) auf dem oberen Viertel des Umfangs der oberen Beschichtungstrommel(23) für die obere Laminatseite und auf das doppelt so lange untere Preßbannd(3) von der vorgezogenen unteren Beschichtungstrommel (23) für die untere Laminathälfte erfolgt.

3. Laminatmaschine nach Anspruch 1 dadurch gekennzeichnet,daß Folien(4) und Trägerstoffe (5) mit beheizbaren Walzen (17)auf Harztemperatur erwärmt werden.

4. Verfahren nach Anspruch 1 dadurch gekennzeichnet,daß die Harzschmelze(19) mittels breitenverstellbaren Breitschlitzdüsen (7) auf die heizbaren Laminierwalzen (13) aufdosiert,durch Erhitzen auf niedrige Viskosität gebracht,und dann sowohl von oben wie von unten in den Trägerstoff gedrückt wird.

5. Verfahren nach den Ansprüchen 1 und 4 dadurch gekennzeichnet,daß zur Aufbringung von Pulverharz (20) ein gekühlter Pulvertrichter (15) verwendet wird, wobei das Harz durch die beheizte Laminier-Walze (13) geschmolzen und durch die Breitschlitzdüse(7) aufgetragen wird.

6. Verfahren nach Anspruch 1 und 4 dadurch gekennzeichnet,daß die nicht beschichteten Randbereiche mittels Randdüsen (14) mit schnellreagierendem Harz (bevorzugt Polyester /Peroxid ) beschichtet werden, welches bis zum Eintritt in die Presse ausgehärtet ist,und somit einen seitlichen Harzaustritt verhindert und eine zusätzliche Randdichtung bei flüssigen und gasförmigen Druckmedien ermöglicht.

7. Verfahren nach den Ansprüchen 1 und 4 dadurch gekennzeichnet, daß nach jeder Lamination eine Dickenkontrolle (18) erfolgt,welche die Dosierung mittels Rakelmesser (16)regelt.

8. Laminatmaschine nach Anspruch 1 dadurch gekennzeichnet, daß die Umlenk-(2)und Beschichtungstrommeln (23) die Preßbänder (3) auf Temperaturen von 100°C bis 300°C aufheizen,die Presse im Temperaturbereich von 40°Cbis 200°C bevorzugt 20-40 °C über der Bandtemperatur sowie im Druckbereich von 5bis 50 bar arbeitet.

9. Laminatmaschine nach Anspruch1 dadurch gekennzeichnet,daß die Bandoberflächen mit Infrarotstrahlern(6) überdeckt sind,sodaß in einem geschlossenen und mit Rollgleitdichtungen (21) abgedichteten evakuierten Raum eine Vorhärtung und Luftblasenfreiheit der beschichteten Trägerstoffe (5) erfolgen kann.

10. Laminatmaschine nach Anspruch 1 dadurch gekennzeichnet,daß die Trägerstoffe (5) bevorzugt oberhalb der Presse angeordnetund durch eine Zwischendecke von der Presse abgetrennt sind, sodaß diese in einem Reinraum steht.

11. Verfahren nach Anspruch 1 dadurch gekennzeichnet,daß zwei oder mehr Schwammwalzen (10) so gestaltet werden,daß die erste eine Reinigungsflüssigkeit z.B:verdünnte Schwefelsäure aufträgt,die Bandoberfläche (3) mit einem Abstreifer reinigt,und anschließend nach dem Aufdüsen von Wasser die Oberfläche mit einer weiteren Schwammwalze gereinigt wird.

12. Laminatmaschine nach Anspruch 1 dadurch gekennzeichnet,daß vor dem Eintritt in die Preßzone (1)-sowie vor den Infrarotstrahlerbereichen (6) zur Beseitigung von Harzverteilungstoleranzen spezielle zum Teil gekühlte Kalibrierwalzen (12)angeordnet sind.

13. Laminatmaschine zur Direktbeschichtung von Platten dadurch gekennzeichnet,daß der Durchmesser der vorderen Beschichtungstrommel (23) vorzugsweise ein Drittel kleiner ist,als die übrigen Trommeln (Zeichnugen Blatt 3 )

**14.** Laminatmaschine zur Herstellung von Basismaterialien aus Glasgewebe dadurch gekennzeichnet,daß die Beschichtungstrommeln(23)einen etwa doppelt so großen Durchmesser aufweisen wie die Umlenktrommeln(2) ( Zeichnungen Blatt 4 )

**15.** Laminatmaschine nach den Ansprüchen 1 u.14 dadurch gekennzeichnet, daß die Presse als Kühlzone ausgelegt ist,sodaß sowohl Thermoplaste im Strahlerbereich(6) aufgeschmolzen und unter Druck und Kühlung mit Trägerstoffen verfestigt werden, als auch drucklos Prepregs hergestellt werden können,

Zeichnungen Blatt 1

Zeichnungen Blatt 2

Zeichnungen Blatt 3

Zeichnungen Blatt 4

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X,Y | EP-A-0 363 794   (K HELD)<br>* das ganze Dokument * | 1,2,4,5,8,<br>9,3,11 | B 32 B 31/20<br>B 30 B 5/06 |
| X | EP-A-0 027 543   (CHEMIE LINZ)<br>* Seite 1, Zeile 1 - Zeile 5 * * Seite 4, Zeile 22 - Zeile 25 * * Seite 5, Zeile 5 - Seite 6, Zeile 3 * *Beispiel 1 4 7 * * Abbildung 1 * | 1,2,8,12 | |
| X | EP-A-0 053 367   (SEKISUI KAGAKU KK)<br>* Seite 7, Zeile 23 - Seite 8, Zeile 10 * * Seite 9, Zeile 5 - Seite 10, Zeile 25 @ Seite 11, Zeile 14 - Zeile 31; Abbildung 1 * | 1,2,7,8 | |
| X | DE-A-3 540 389   (SANTRADE)<br>* Spalte 5, Zeile 6 - Zeile 10 * * Spalte 5, Zeile 35 - Spalte 7, Zeile 5; Abbildungen 1-5 * | 1,2,5,8,9 | |
| A | EP-A-0 215 392   (K HELD)<br>* Anspruch 1; Abbildung 2 * | 11 | |
| Y | EP-A-0 144 822   (K HELD)<br>* Seite 10, Zeile 24 - Seite 11, Zeile 14; Ansprüche 1-4; Abbildungen 1-3 * | 3,11 | **RECHERCHIERTE SACHGEBIETE (Int. Cl.5)**<br><br>B 32 B |
| E | DE-A-3 928 849   (G SIEMPELKAMP)<br>* Spalte 2, Zeile 28 - Zeile 50 * * Spalte 3, Zeile 49 - Zeile 48 * | 3,6 | B 30 B<br>B 29 C |

Der vorliegende Recherchenbericht wurde für alle Patentansprüche erstellt

| Recherchenort | Abschlußdatum der Recherche | Prüfer |
|---|---|---|
| Den Haag | 20 August 91 | PHILPOTT G.R. |